# EUROPEAN PATENT SPECIFICATION

(11) **EP 1 545 833 B1**
(45) Date of publication and mention of the grant of the patent: **15.06.2011**
(21) Application number: 03765257.5
(22) Date of filing: 22.07.2003
(51) Int. Cl.: B24B 1/00

(54) **RINSING AFTER CHEMICAL-MECHANICAL PLANARIZATION PROCESS APPLIED ON A WAFER**
SPÜLEN NACH EINEM AUF EINEN WAFER ANGEWANDTEN CHEMISCH-MECHANISCHEN PLANARISIERUNGSPROZESS
RINCAGE APRES PLANARISATION CHIMIO-MECANIQUE D'UNE TRANCHE

(30) Priority: 23.07.2002 FR 0209336; 23.12.2002 US 446985 P
(43) Date of publication of application: 29.06.2005
(73) Proprietor: S.O.I.Tec Silicon on Insulator Technologies, 38190 Bernin (FR)
(72) Inventor: FILIPOZZI, Laurent, F-38340 Voreppe (FR); METRAL, Frédéric, 38660 ST HILAIRE DU TOUVET FRANCE (FR)
(74) Representative: Texier, Christian
(86) International application number: PCT/IB2003/003798
(87) International publication number: WO 2004/009289

(56) References cited:
- US-A- 5 996 594
- US-B1- 6 336 945
- M.L. FREE: "Using surfactants in iron-based CMP slurries to minimize residual particles" MICROMAGAZINE, [Online] XP002266271 Retrieved from the Internet: <URL:http://www.micromagazine.com/archive/ 98/05/free.html> [retrieved on 2004-01-07] cited in the application

## Description

The present invention relates in general to the polishing of wafers of non-metallic materials containing silicon, particular silicon wafers.

More specifically, the invention retates to a method for the chemical-mechanical planarization of a wafer of a non-metallic material containing silicon, comprising:
- a step of polishing the surface of the wafer using a polishing plate together with a polishing solution, the said polishing solution comprising an agent capable of attacking the said surface chemically and abrasive particles capable of attacking this surface mechanically;
- a step of rinsing the residues resulting from the polishing step, using a polishing plate together with a rinsing solution; and
- a cleaning step.

Methods of the abovementioned type are already known. An example of such a method is disclosed in US-A-5 996 594.

The expression "chemical-mechanical planarization" is understood to mean polishing that combines mechanical attack of the surface of the wafer with chemical etching of the same surface, optionally followed by a rinsing and/or cleaning step. This type of method is also known by the abbreviation CMP (Chemical Mechanical Planarization).

For these purposes, the polishing is carried out using a solution containing a chemical agent capable of attacking the surface of the wafer chemically and abrasive particles capable of eroding this same surface mechanically.

In the known applications, the wafer of material to be polished may have a thickness of the order of a few tens of microns, or more.

These wafers may consist of a single layer of material or they may be multilayer structures.

The polishing plates are generally in the form of discs, the surface of which has a coating of suitable composition and texture.

These plates are applied, with a controlled pressure, against the surface of the wafer to be polished and/or rinsed, while being moved with respect to the wafer (typically rotated about an axis perpendicular to the surface of the wafer).

The hardness of the plate for the polishing is furthermore, and in general, greater than that of the plate for the rinsing.

It is also known to employ separate plates for the polishing and for the rinsing.

If the two steps are carried out with the same plate, the residues resulting from polishing remain trapped between the plate and the surface to be rinsed. These residues are then carried along by the plate and mixed with the rinsing solution, and continue to erode the surface of the wafer. This is not generally desired.

This is because the role of the rinsing is specifically to remove as much as possible of these residues resulting from the polishing, before proceeding to the final cleaning of the surface of the wafer - these residues would be liable subsequently to cause damage in the integrated circuits that are or will be formed on the wafer.

It should be pointed out that "polishing residue" means both the solid residues coming from the abrasive particles used for the polishing and the possible metallic contaminations on the surface of the wafer.

The step of rinsing the polished wafer, which is interposed between the polishing step and the cleaning step, is, in known techniques, carried out with solutions comprising in general deionized water (DIW).

One limitation of these DIW rinsing steps is that they must be long enough to allow the polishing residues to be property removed - the associated delays reduce the rate of production of polished wafers, this being detrimental in an industrial context.

It is also known to mix the rinsing DIW with an additive of the NH₄OH/H₂O₂ (SC1) or HCl/H₂O₂ (SC2) type, which makes it possible to increase the rate of removal of the polishing residues.

However, to do this, these additives generally have a tendency to attack the surface of the wafer over a thickness of the order of a few nanometres by chemical etching.

Although such additional etching is compatible with the tolerances associated with the surface finish specifications in the case of thin layers having a thickness of a few microns, it becomes problematic in the case of thinner layers.

In particular, for the chemical-mechanical planarization of wafers of a non-metallic material containing silicon and comprising an active thin layer having a structure of the SOI (Silicon-On-Insulator) type, the known techniques of the abovementioned type may prove to be unsuitable.

Since the thickness of these active layers tends to decrease, it will in fact be desirable to control the thickness of the wafer after polishing with a precision of the order of plus or minus 5 nanometres, something that cannot be envisaged in the case of rinsing with additives of the SC1 or SC2 type.

Moreover, a method for the chemical-mechanical planarization of a surface of a tungsten wafer that includes a step of polishing the surface, especially by means of a polishing solution containing surfactants, is known. This method is described by M.L. Free in Micromagazine, May 1998 ("Using surfactants in iron-based CMP slurries to minimize residual parlicles*"*)*.*

By "surfactants" we mean agents in solution, such as for example detergents or soaps, that are capable of reducing the interfacial tension between the solution and the wafer and of increasing the wettability of the solution on the surface of the wafer. They may thus help to remove the residues present on the surface of the wafer.

It should be mentioned that, during a polishing step of a CMP method, the polishing is carried out by two principal actions:
- a mechanical action performed by the abrasive particles on the wafer ;
- a chemical action performed by the etchant on the wafer.

In the case of the polishing of a metal surface, such as that described by Free, these two actions are of approximately comparably importance.

This is because, since the alumina abrasive particles are of quite a large size (around 1 micron), their action may not be underestimated compared with that of the chemical etchants.

These abrasive particles, because of their considerable size, may however cause damage on the surface to be polished (such as scratches or holes).

Adding surfactants to the polishing solution prevents this damage, thus softening the mechanical abrasive action of the polishing.

In order to polish surfaces of other types of material, such as non-metallic materials containing silicon, in which the chemical etchant is typically basic, the teaching of the method described by Free cannot, however, be transposed as the addition of surfactants during polishing would greatly increase the polishing time.

This is because, for these types of material, since the abrasive particles used are smaller in size the chemical action is dominant over the mechanical action, unlike the alumina abrasive particles used by Free on a metal surface.

Furthermore, the supply during polishing of surfactants - which are generally acidic - would result in the chemical action associated with the basicity of the polishing solution being reduced or even counteracted.

The wafer polishing time would therefore be substantially longer. This would reduce the productivity of a wafer fabrication line that includes such a polishing step.

Thus, the polishing time for silicon may typically be increased by a factor of ten depending on whether or not a surfactant is used in the polishing solution.

Moreover, the risk of damage that the small abrasive particles might cause on the surface of the wafer is reduced compared with larger abrasive particles, and the benefit of supplying a surfactant during polishing in order to reduce their aggressiveness, as proposed by Free, then becomes less obvious.

The method consisting in supplying surfactants during polishing therefore does not seem to be suitable for effective chemical-mechanical planarization of surfaces comprising such materials.

In the US 5 996 594 document, the surfactant is introduced after the polishing step.

The method disclosed by this document attempts to resolve a particular problem of gelation of the abrasive particles, due to a pH shock which can occur between the polishing step of a CMP process (basic pH) and the rinsing step (acid pH), by melting surfactant to a basic solution to obtain a basic rinsing solution.

It is an object of the invention to improve the efficiency of CMP for such materials.

To achieve this object the invention provides a method of chemical-mechanical planarization (CMP) onto a wafer having a non-metallic surface material containing at least partly silicon according to claim 1.

Preferred aspects of the method according to the invention are the following:
- the polishing solution has a basic pH and the rinsing solution has an acid pH, so that the progressive introduction of the rinsing solution of step b) changes progressively the pH of the polishing solution to terminate the chemical attack of the chemical agent on the wafer surface,
- the rate of injection of the rinsing and cleaning solutions onto the surface of the wafer is such that the pH of the solution present on the surface of the wafer progressively changes from a basic pH to a neutral pH,
- the non-metallic surface material containing silicon of the wafer is one within the following list: crystalline silicon, silica, glass and quartz,
- the chemical agent has a pH of between about seven and ten, preferably between about eight and ten,
- the chemical agent is a nitrogen-containing base, such as aqueous ammonia,
- the rinsing solution has a pH between three and five, preferably about four,
- the rinsing solution includes a surfactant,
- the surfactant solution is an aqueous solution containing a polyoxyalkylene alkyl ether,
- the critical micelle concentration of the surfactant is close to 0.1% or less,
- the rinsing step b) starts before the solution containing the particulate residues is dried,
- the rinsing solution and the cleaning solution includes deionized water.
- the rinsing of step b) occurs at a rinsing location that is different from that used for the polishing step a),
- the rinsing step b) further comprises the use of a polishing plate different from that used for the polishing step a), at the same time as injection of the rinsing solution,
- the plate for the polishing and the plate for the rinsing are each covered with a textured material,
- the cleaning step employs a polishing plate together with a cleaning solution,
- the plate for the cleaning is a plate separate from the plate for the polishing and from the plate for the rinsing,
- the plate for the cleaning is covered with a textured material,
- it further comprises processing the wafer surface to form an integrated circuit component that is hosted by the material of the wafer surface, and
- it further comprises drying the wafer prior to subsequent processing.

The invention also provides the application of such a method as mentioned above to the chemical-mechanical planarization of a surface of a semiconductor-on-insulator structure, the semiconductor containing silicon and the insulator advantageously being silica, glass or quartz.

Further aspects, objects and advantages of the present invention will become more clearly apparent on reading the following detailed description of a preferred embodiment thereof, given by way of non-limiting example and with reference to the appended drawings in which:
- Figure 1 shows, in a perspective view, a CMP device used in the method according to the invention;
- Figure 2 shows, in a top view, a CMP device used in a method according to the invention.

The wafers that are planarized according to the invention have a thickness possibly ranging from a few micrometres to a few millimetres.

In general, a wafer includes a surface layer which may range from a few nanometres to a few micrometres, more specifically between one and few tens of nanometres, representing the active layer of the wafer that has or is intended to receive electronic components.

This layer is made of a non-metallic material containing silicon.

The non-metallic material containing silicon of this layer may for example be only crystalline silicon, silica, glass, quartz or another compound.

In a preferred situation, it is silicon, forming for example a portion of the upper layer of an SOI (Silicon-On-Insulator) structure which itself runs within the upper portion of the wafer.

The method according to the invention comprises a polishing first step, which has the purpose of optimally planarizing at least one face of the wafer to be polished and carries out the following combined three actions:
- macroscopic mechanical attack of the wafer by rubbing forces caused by at least one polishing plate rubbing on at least one face of the wafer;
- microscopic mechanical attack of the wafer by abrasive particles contained in a polishing solution; and
- chemical attack of the wafer by a chemical agent contained in the polishing solution.

In general, these three actions are combined simultaneously with the supply of a polishing solution containing the abrasive particles and the chemical agent while the wafer is being rubbed by the polishing plate(s).

The surface of the plate is preferably plane and parallel to the wafer, undergoing a rotational movement with respect to the latter about an axis, and, advantageously, all these parameters are particularly calibrated so that the plate exerts rubbing forces on the wafer that are as constant as possible in value over the entire surface of the wafer.

Advantageously, the plate is covered with a fabric.

Later, we will see examples of a mechanical polishing device that can be used by the present invention.

As regards the abrasive particles, these have particularly calibrated sizes so as, on the one hand, to be large enough for the abrasive particles to abrade the surface of the wafer suitably but, on the other hand, not to abrade the surface excessively, which could thus cause substantial surface damage, such as scratches or "pin holes".

The particles used for abrading silicon surfaces have sizes of the order of 0.1 microns. This is much smaller than the abrasive particles that Free describes in his document as having a typical diameter of 1 micron.

The concentration of these abrasive particles used for polishing silicon is furthermore substantially lower than the concentrations normally used to polish materials such as tungsten.

The nature of the abrasive particles is chosen for their hardness compared with a surface containing, at least partly, silicon, this surface being attacked chemically, for their resistance to the chemical agent of the polishing solution and for their ability not to excessively agglomerate with one another.

Although the concentration of abrasive particles for the abrasion of metallic materials is typically between 5% and 25%, in the case of the abrasion of silicon it is typically between 0.01 % and 1%.

The concentration of abrasive particles for silicon is in general more specifically between 0.2% and 0.7%, and preferably between 0.3% and 0.4%.

The abrasive particles used here are advantageously silica particles.

The function of these injected abrasive particles is thus to rub on the surface of the wafer, tearing off therefrom thin films of semiconductor materials.

The abrasion is facilitated by the action of the polishing plate, which presses not only onto its surface but also presses the abrasive particles against the wafer, thus entraining them over the entire surface of the wafer.

The abrasion may also be assisted by the liquid flux from the injection of the solution onto the surface of the wafer, which thus displaces the abrasive particles thereon.

The chemical agent added to the polishing solution is in general chosen to create chemical reactions on the surface of the wafer, making it possible for wafer surface particles to be weakened or even detached; it may thus act as a supplementary aid to the abrasive action.

The chemical agent has a basic pH so as to favour the chemical attack of materials such as crystalline silicon, silica (also denoted here as SiO₂), glass and quartz.

The base of the polishing solutions containing the abrasive particles and the chemical agent is advantageously water having a particularly neutral pH and preferably deionized.

In one particular embodiment of the polishing solution, a surface agent, capable of increasing the wettability of the polishing solution on the surface of the wafer, is added as a solution, thus allowing the abrasive particles and the dissolved chemical agent to be distributed so that the abrasion and the chemical attack are particularly homogeneous.

The combination of the said three simultaneous actions - rubbing, abrasion and chemical attack - gives the wafer quite rapidly a very good surface finish.

The thickness to be polished is controlled by two means:
- firstly by the parametres determining the action of this polishing (speed of rotation of the plate, pressure exerted normal to the plate, concentration of the abrasive particles, concentration of the chemical agent, etc.); and
- secondly, by the means used to stop the three combined actions.

The first means of controlling the thickness to be polished is direct: the parametres such as the concentrations of components and the speed of rotation of the plate are easily adjustable and their effects on the polishing, because of the numerous experiments carried out, are predictable and reproducible with satisfactory tolerances, possibly within a nanometre.

The second means of controlling the thickness to be polished is more indirect: although stopping the rotation of the polishing plate or plates terminates the action of this or them on the wafer, on the other and the abrasive and chemical actions continue as long as the agent and particles that produce them remain on the surface of the wafer.

Apart from control of the termination of this microscopic attack, and therefore the time over which it takes place, the removal of all the other residual particles resulting from the polishing step (particles torn off the surface of the wafer, particles resulting from certain wear of the fabrics possible covering the polishing plate(s), etc.) must be conducted effectively.

For this purpose, effective wafer rinsing and cleaning steps are therefore needed.

Thus, the wafer rinsing step must make it possible to remove these particles and to put an end, in a controllable manner, to these "latent" surface attack actions.

According to the invention, the use of a surfactant in the aqueous rinsing solution is an effective means for completely removing the undesirable particles from the surface of the wafer, by acting both physicochemically and chemically.

Firstly, the physico-chemical action of a surfactant particle is closely associated with the fact that it usually possesses a hydrophilic part and a hydrophobic part.

The hydrophobic part, usually formed by a long carbon chain of the alkyl type, has a tendency to wish to flee the water and therefore to be fixed to the solid parts formed by the surface of the wafer and the residual particles on the surface and in suspension.

As regards the hydrophilic part, since this has a tendency to seek contact with water, the surfactant molecules mutually repel one another, exerting lateral pressure which reduces the solution/wafer surface interfacial tension and thus promotes spreading of the rinsing solution over the surface of the wafer and therefore good wettability of the solution on the surface.

The surfactant particles, which are adsorbed on the surface of the wafer, reduce the attractive forces of the Van de Waals type that are exerted between the residues and the surface.

The surfactant particles that are bonded to the residues are sufficiently numerous in solution, above a certain concentration, called the critical micelle concentration (or CMC), to create micelles in suspension, that is to say aggregates of residual particles to which the surfactant molecules are attached by their hydrophobic parts and put into suspension by their hydrophilic parts that seek contact with water.

The surfactants therefore make it possible to disperse the residual particles in the rinsing solution and thus reduce their deposition on the surface, and allow them to .be removed.

Moreover, and in particular, the CMC depends on the size of the residual particles to be removed. Now, since the residual particles normally found in solution after such semiconducting surfaces have been polished are generally smaller than those found in solutions after metallic surfaces are polished (described above), the CMC is all the lower.

Secondly, the chemical action of a surfactant solution depends on the value of its pH.

For surface materials such as silicon, quartz, glass or silica, chemical attack of the surface by the polishing solution takes place at a basic pH, which weakens the bonds of the wafer surface particles.

Adding an acid surfactant to the polishing solution therefore promotes the rapid termination of the chemical action of the polishing solution.

For a surface containing silicon, the chemical action is in general predominant over the mechanical action, since the sizes of the abrasive particles resulting from polishing the silicon surface are small.

Such rinsing with an acid surfactant therefore substantially stops the polishing action and allows its effects on the wafer to be controlled. Consequently, the post-polishing thickness is thus guaranteed and reproducible.

Termination of the polishing is thus controlled.

It should be noted that the sizes of the abrasive particles contained in a polishing solution without surfactants according to the invention are small enough not to create, in the absence of surfactants during the polishing stage, obvious surface damage such as that caused by the abrasive particles contained, for example, in polishing solutions without surfactants for tungsten surfaces.

It is recommended to inject the rinsing solution before drying the polishing solution on the surface of the wafer, since the particulate residues thus dried would then be difficult to remove.

The surfactants may also play an electrostatic role, by forcing, by their chemical action, the residual particles and the surface of the wafer to disturb their electrical bonding.

This is in particular the case for silicon surfaces abraded by silica molecules, using a basic polishing solution. The basicity of the polishing solution used then causes the particles to be electrically attracted by the surface of the wafer. The acidity provided by the (acid) surfactant injected during rinsing will in fact, on the contrary, reduce the attraction between the abrasive particles and the surface of the wafer, or even repel the abrasive particles therefrom.

The electrical neutrality of a surfactant prevents an undesirable influence of the latter on the electrical properties of the semiconductor surface, with an additional risk of intrusion of contaminants into the surface material.

However, it is also possible to act more strongly from the electrical standpoint by choosing ionic surfactants that have the opposite polarity to that of the material present on the surface of the wafer: thus, the ionized molecules collect together on the surface of the wafer and reverse the polarity of the electric potential of this surface so as to repel the residual particles of the same charge, which particles would have a tendency to bond to the surface.

The aqueous solution containing the surfactant(s) used is preferably deionized water.

This rinsing is advantageously accompanied by the action of one or more rinsing plate(s) on the wafer, identical to the polishing plate, advantageously covered with a pliant fabric and in contact with the wafer to be rinsed.

The rinsing plates are made to move with respect to the wafer, preferably rotated about an axis perpendicular to the plane of the wafer.

The plate/wafer contact combined with the movement of the plate contributes to displacing the liquid present on the wafer surface and to removing it more rapidly.

Finally, a step of cleaning the wafer surface with water gives the surface a neutral pH and allows the final residues and chemical products to be removed.

Advantageously, the cleaning water is deionized.

The cleaning action is advantageously accompanied by the action of a cleaning plate identical to the rinsing plate.

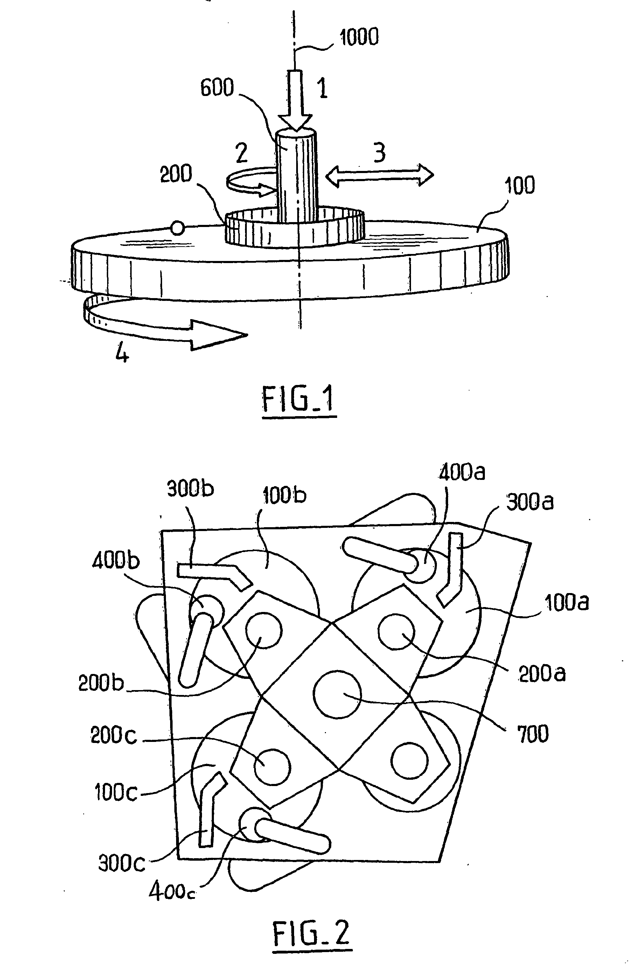

Shown in Figure 1 is a chemical-mechanical planarization device which thus allows the roughness of one or both faces of a wafer to be corrected.

A polishing head 200 able to rotate about a drive shaft 600 has an internal cavity suitable for housing a wafer.

It should be pointed out that the wafer does not appear in the figures as it is intended to be enclosed in the internal cavity of the polishing head. For this purpose, the shape and the dimensions of the internal cavity of the polishing head correspond substantially to the shape and to the dimensions of the wafer to be polished.

A polishing plate 100, also capable of being rotated, closes the cavity of the polishing head 200, which is pressed against the surface of the plate, thus enclosing the wafer between the bottom of the cavity of the polishing head 200 and the surface of the plate.

It should be pointed out that the axis 1000 about which the plate 100 rotates is stationary.

The shaft 600 about which the polishing head 200 itself rotates is parallel to the rotation axis 1000 of the plate, but may be shifted in the plane perpendicular to these two axes of rotation (which plane is also the plane in which the polishing plate 100 and the wafer to be polished lie).

A force 1 applied along the shaft 600 to the polishing head brings the wafer into contact with the transverse wall of the cavity of the head 200 and with the upper face of the plate 100.

Typically, this force 1 is equal to 0.14 kg/cm² (2 psi).

The respective rotational movements 2 and 4 of the head 200 and the plate 100 relative to the wafer cause rubbing on at least one face of latter and thus cause this face or these faces to be polished.

The speeds of rotation associated with the movements 2 and 4 are typically between 30 rpm and 60 rpm.

In a preferred embodiment, the polishing head 200, accompanied by the wafer, is moved over the upper surface of the polishing plate 100 in a defined path so as to make the polishing as homogeneous as possible. This movement may, for example, be a translational to-and-fro movement 3 along a defined axis or a helical movement.

Advantageously, the polishing plate is coated with a textured material or fabric.

The polishing, rinsing and/or cleaning solutions are advantageously injected across the plate 100, wetting the fabric which thus optimally distributes the solution over the entire surface of the wafer.

In a first embodiment of the plates, the said polishing, rinsing and cleaning functions of the plates are fulfilled by just one plate.

However, to improve the overall productivity of the method, devices having several plates will be preferred.

In a second embodiment of the plates, the polishing function is fulfilled by a polishing plate and the rinsing and cleaning functions are fulfilled by just one plate called the rinsing/cleaning plate. This embodiment, which decouples the polishing from the rinsing/cleaning improves the quality of the rinsing by using, for the rinsing, a "virgin" plate devoid of any particulate residues that might remain attached to a plate.

In a third embodiment of the plates, the polishing plate, the rinsing plate and the cleaning plate are separate plates. Compared with the second embodiment, the third embodiment decouples the rinsing from the cleaning and thus improves the final cleanliness of the wafer surface by using, for the cleaning, a virgin plate devoid of any particulate residues that might remain attached to a rinsing plate.

Figure 2 shows a CMP device according to this third embodiment. This device can implement a CMP method according to the invention by step of correction of the surface roughness of a wafer, followed by a rinsing step and a cleaning step. It comprises a polishing plate 100a, a rinsing plate 100b, a cleaning plate 100c and three solution injectors 300a, 300b, 300c associated with these three plates respectively.

Three polishing heads 200a, 200b, 200c, joined together, are placed at an equidistance away from a rotation shaft 700 and move relative to the latter, with the principle of a carousel.

Preferably, the plates 100a, 100b, 100c are in contact with three brushing devices 400a, 400b, 400c respectively, so as to be able periodically to remove surface residues from the plates.

In one way of using this device, the plate 100a and the head 200a perform a polishing action identical to that indicated in Figure 1. In addition to this mechanical polishing action a polishing solution supplied by the injector 100a performs chemical etching by means of an etchant and mechanical etching by means of abrasive particles.

The polishing head 100a then takes the wafer to the second, rinsing plate 100b and finally to the third, cleaning plate 100c by a rotational movement of the head 100a about the shaft 700 so as to carry out the respective operations of rinsing and cleaning the surface of the wafer by means of respective rinsing and cleaning solutions injected via the injectors 300b and 300c.

Similar mechanical polishing or CMP methods may be used to apply the roughness correction to the faces of the wafer.

One illustrative example of application of a method according to the invention is the planarization of silicon-on-insulator (or SOI) structures.

Since the surface of the wafer is made of silicon, the appropriate polishing solution is a basic solution having a pH ranging between 7 and 10, and preferably between 8 and 10.

preferably, the chemical agent is a nitrogen-containing base such as aqueous ammonia.

The abrasive particles are preferably silica particles, with sizes of the order of a tenth of a micron.

The surfactant used preferably has a pH of between 3 and 5, more particularly around 4, with a CMC close to 0.1% or less.

An example of a surfactant acting in accordance with the method according to the invention is NCW-1001 from Wako Chemical GmbH, a non-ionic surfactant of polyoxyalkylene alkyl ether composition, having a pH of approximately 3.7 and a CMC of around 0.01% at room temperature.

As regards the rinsing of a silicon surface polished beforehand, it is preferred for the rinsing solution to be injected progressively: too rapid an injection would result in too rapid a reduction in the pH value of the solution present on the surface of the wafer and would consequently increase the size of the silica particles by agglomeration and therefore risk suffering abrasion damage caused by these more bulky particle agglomerates.

To do this, the duration of the rinsing step is around 50% of the polishing duration.

Also preferable is the polishing device shown in Figure 2 which, by means of the three successive plates and management of the rates of injection of the rinsing and cleaning solutions, helps to achieve a progressive change from the basic (polishing) pH to a neutral pH, then to an acid (rinsing) pH and finally to a neutral (cleaning) pH.

## Claims

1. Method of chemical-mechanical planarization (CMP) onto a wafer having a non-metallic surface material containing at least partly silicon, comprising the following steps :
a) polishing the surface of the wafer using a polishing plate together with a polishing solution, the said polishing solution comprising a chemical agent for chemical attacking the said surface and abrasive particles for mechanically attacking the said surface;
b) rinsing residues resulting from the polishing step; and
c) final cleaning;
**characterized in that** the rinsing solution of step b) is progressively introduced onto the wafer surface so that the chemical attack of step a) is controllably stopped before going beyond a desired planarization.

2. Method according to the preceding claim, **characterized in that** the polishing solution has a basic pH and the rinsing solution has an acid pH, so that the progressive introduction of the rinsing solution of step b) changes progressively the pH of the polishing solution to terminate the chemical attack of the chemical agent on the wafer surface.

3. Method according to the preceding claim, **characterized in that** the rate of injection of the rinsing and cleaning solutions onto the surface of the wafer is such that the pH of the solution present on the surface of the wafer progressively changes from a basic pH to a neutral pH.

4. Method according to either of the two preceding claims, **characterized in that** the non-metallic surface material containing silicon of the wafer is one within the following list: crystalline silicon, silica, glass and quartz.

5. Method according to one of the preceding claims, **characterized in that** the chemical agent has a pH of between about seven and ten, preferably between about eight and ten.

6. Method according to the preceding claim, **characterized in that** the chemical agent is a nitrogen-containing base, such as aqueous ammonia.

7. Method according to one of the three preceding claims, **characterized in that** the rinsing solution has a pH between three and five, preferably about four.

8. Method according to the preceding claim, **characterized in that** the rinsing solution includes a surfactant.

9. Method according to the preceding claim, **characterized in that** the surfactant solution is an aqueous solution containing a polyoxyalkylene alkyl ether.

10. Method according to one of the preceding claims, **characterized in that** the critical micelle concentration of the surfactant is close to 0.1 % or less.

11. Method according to one of the preceding claims, **characterized in that** the rinsing step b) starts before the solution containing the particulate residues is dried.

12. Method according to one of the preceding claims, **characterized in that** the rinsing solution and the cleaning solution includes deionized water.

13. Method according to one of the preceding claims, **characterized in that** the rinsing of step b) occurs at a rinsing location that is different from that used for the polishing step a).

14. Method according to the preceding claim, **characterized in that** the rinsing step b) further comprises the use of a polishing plate different from that used for the polishing step a), at the same time as injection of the rinsing solution.

15. Method according to the preceding claim, **characterized in that** the plate for the polishing and the plate for the rinsing are each covered with a textured material.

16. Method according to either of the two preceding claims, **characterized in that** the cleaning step employs a polishing plate together with a cleaning solution.

17. Method according to the preceding claim, **characterized in that** the plate for the cleaning is a plate separate from the plate for the polishing and from the plate for the rinsing.

18. method according to the preceding claim, **characterized in that** the plate for the cleaning is covered with a textured material.

19. Method according to one of the preceding claims, **characterized in that** it further comprises processing the wafer surface to form an integrated circuit component that is hosted by the material of the wafer surface.

20. Method according to the preceding claims, **characterized in that** it further comprises drying the wafer prior to subsequent processing.

21. Application of a method according to one of the preceding claims, to a CMP of a semiconductor-on-insulator structure, the semiconductor being of a material containing at least partly silicon.

22. Application of the method according to the preceding claim, for which the insulator is silica, glass or quartz.

## Patentansprüche

1. Verfahren zur chemisch-mechanischen Planarisierung (CMP) auf einem Wafer mit einem nicht-metallischen Oberflächenmaterial, das wenigstens teilweise Silizium enthält, die folgenden Schritte umfassend:
a) Polieren der Oberfläche des Wafers unter Verwendung einer Polierplatte zusammen mit einer Polierlösung, wobei die Polierlösung einen chemischen Wirkstoff zum chemischen Bearbeiten der Oberfläche und abtragende Partikel zum mechanischen Bearbeiten der Oberfläche umfasst;
b) Spülen von Rückständen, die sich aus dem Polierschritt ergeben; und
c) abschließendes Reinigen;
**dadurch gekennzeichnet, dass** die Spüllösung aus Schritt b) nach und nach auf die Waferoberfläche gegeben wird, so dass die chemische Behandlung aus Schritt a) kontrolliert gestoppt wird, bevor sie über eine gewünschte Planarisierung hinaus geht.

2. Verfahren nach dem vorhergehenden Anspruch, **dadurch gekennzeichnet, dass** die Polierlösung einen basischen pH-Wert und die Spüllösung einen sauren pH-Wert hat, so dass das allmähliche Zugeben der Spüllösung in Schritt b) den pH-Wert der Polierlösung zunehmend ändert, um so die chemische Einwirkung des chemischen Wirkstoffs auf die Waferoberfläche zu beenden.

3. Verfahren nach dem vorhergehenden Anspruch, **dadurch gekennzeichnet, dass** die Zugaberaten für die Spüllösung und die Reinigungslösung auf die Oberfläche des Wafers so sind, dass der pH-Wert der auf der Waferoberfläche befindlichen Lösung sich fortschreitend von einem basischen pH-Wert zu einem neutralen pH-Wert ändert.

4. Verfahren nach einem der beiden vorhergehenden Ansprüche, **dadurch gekennzeichnet, dass** das Silizium enthaltende nicht-metallische Oberflächenmaterial des Wafers eines aus der folgenden Liste ist: kristallines Silizium, Siliziumdioxid, Glas und Quarz.

5. Verfahren nach einem der vorhergehenden Ansprüche, **dadurch gekennzeichnet, dass** der chemische Wirkstoff einen pH-Wert zwischen etwa sieben und zehn und vorzugsweise zwischen etwa acht und zehn hat.

6. Verfahren nach dem vorhergehenden Anspruch, **dadurch gekennzeichnet, dass** der chemische Wirkstoff eine Stickstoff enthaltende Base ist, wie etwa wässriges Ammoniak.

7. Verfahren nach einem der drei vorhergehenden Ansprüche, **dadurch gekennzeichnet, dass** die Spüllösung einen pH-Wert zwischen drei und fünf und vorzugsweise von etwa vier hat.

8. Verfahren nach dem vorhergehenden Anspruch, **dadurch gekennzeichnet, dass** die Spüllösung einen oberflächenaktiven Stoff enthält.

9. Verfahren nach dem vorhergehenden Anspruch, **dadurch gekennzeichnet, dass** die Lösung mit dem oberflächenaktiven Stoff eine wässrige Lösung ist, die einen Polyoxyalkylen-Alkylether enthält.

10. Verfahren nach einem der vorhergehenden Ansprüche, **dadurch gekennzeichnet, dass** die kritische Mizellenbildungskonzentration des oberflächenaktiven Stoffs nahe bei 0,1 % oder darunter liegt.

11. Verfahren nach einem der vorhergehenden Ansprüche, **dadurch gekennzeichnet, dass** der Spülschritt b) startet, bevor die Lösung, die die partikelförmigen Rückstände enthält, getrocknet ist.

12. Verfahren nach einem der vorhergehenden Ansprüche, **dadurch gekennzeichnet, dass** die Spüllösung und die Reinigungslösung entionisiertes Wasser enthalten.

13. Verfahren nach einem der vorhergehenden Ansprüche, **dadurch gekennzeichnet, dass** der Spülvorgang aus Schritt b) an einem Spülort stattfindet, der von demjenigen verschieden ist, der für den Polierschritt a) verwendet wird.

14. Verfahren nach dem vorhergehenden Anspruch, **dadurch gekennzeichnet, dass** der Spülschritt b) außerdem die Verwendung einer Polierplatte umfasst, die verschieden von derjenigen ist, die für den Polierschritt a) verwendet wird, und dies gleichzeitig mit der Zugabe der Spüllösung.

15. Verfahren nach dem vorhergehenden Anspruch, **dadurch gekennzeichnet, dass** die Platte für das Polieren und die Platte für das Spülen jeweils mit einem strukturierten Material überzogen sind.

16. Verfahren nach einem der zwei vorhergehenden Ansprüche, **dadurch gekennzeichnet, dass** der Reinigungsschritt eine Polierplatte zusammen mit einer Reinigungslösung einsetzt.

17. Verfahren nach dem vorhergehenden Anspruch, **dadurch gekennzeichnet, dass** die Platte zum Reinigen eine von der Platte zum Polieren und von der Platte zum Spülen getrennte Platte ist.

18. Verfahren nach dem vorhergehenden Anspruch, **dadurch gekennzeichnet, dass** die Platte zum Reinigen mit einem strukturierten Material überzogen ist.

19. Verfahren nach einem der vorhergehenden Ansprüche, **dadurch gekennzeichnet, dass** es außerdem die Bearbeitung der Waferoberfläche umfasst, um eine integrierte Schaltungskomponente auszubilden, die in das Material der Waferoberfläche eingebettet ist.

20. Verfahren nach den vorhergehenden Ansprüchen, **dadurch gekennzeichnet, dass** es außerdem das Trocknen des Wafers vor einer nachfolgenden Bearbeitung umfasst.

21. Anwendung eines Verfahrens nach einem der vorhergehenden Ansprüche auf eine CMP einer Halbleiter-auf-Isolator-Struktur, wobei der Halbleiter aus einem Material besteht, das wenigstens teilweise Silizium enthält.

22. Anwendung des Verfahrens nach dem vorhergehenden Anspruch, wobei der Isolator Siliziumdioxid, Glas oder Quarz ist.

## Revendications

1. Procédé de planarisation mécano-chimique (CMP) d'une tranche comportant un matériau non-métallique de surface contenant au moins en partie du silicium, comprenant les étapes suivantes :
a) le polissage de la surface de la tranche au moyen d'un plateau de polissage associé à une solution de polissage, ladite solution de polissage comprenant un agent chimique apte à attaquer chimiquement ladite surface ainsi que des particules abrasives aptes à attaquer mécaniquement ladite surface ;
b) le rinçage des résidus issus de l'étape de polissage ; et
c) un nettoyage final ;
**caractérisé en ce que** la solution de rinçage de l'étape b) est progressivement introduite sur la surface de la tranche, de manière à ce que l'attaque chimique de l'étape a) soit arrêtée à un moment voulu avant d'aller au-delà d'une planarisation souhaitée.

2. Procédé selon la revendication précédente, **caractérisé en ce que** la solution de polissage a un pH basique et la solution de rinçage a un pH acide, de sorte que l'introduction progressive de la solution de rinçage de l'étape b) modifie progressivement le pH de la solution de polissage afin d'arrêter l'attaque chimique de l'agent chimique sur la surface de la tranche.

3. Procédé selon la revendication précédente, **caractérisé en ce que** la vitesse d'injection des solutions de rinçage et de nettoyage sur la surface de la tranche est telle que le pH de la solution présente sur la surface de la tranche évolue progressivement d'un pH basique vers un pH neutre.

4. Procédé selon l'une des deux revendications précédentes, **caractérisé en ce que** le matériau non-métallique de surface contenant du silicium de la tranche appartient à la liste suivante : silicium cristallin, silice, verre, quartz.

5. Procédé selon l'une des revendications précédentes, **caractérisé en ce que** l'agent chimique a un pH compris entre environ sept et dix, et de préférence entre environ huit et dix.

6. Procédé selon la revendication précédente, **caractérisé en ce que** l'agent chimique est une base azotée, telle que l'ammoniaque.

7. Procédé selon l'une des trois revendications précédentes, **caractérisé en ce que** la solution de rinçage a un pH compris entre trois et cinq, et est de préférence d'environ quatre.

8. Procédé selon la revendication précédente, **caractérisé en ce que** la solution de rinçage contient un tensioactif.

9. Procédé selon la revendication précédente, **caractérisé en ce que** la solution de tensioactif est une solution aqueuse contenant un éther d'alkyle polyoxyalkyléné.

10. Procédé selon l'une des revendications précédentes, **caractérisé en ce que** la concentration micellaire critique du tensioactif est proche de 0,1 % ou est inférieure à 0,1 %.

11. Procédé selon l'une des revendications précédentes, **caractérisé en ce que** l'étape de rinçage b) commence avant que la solution contenant les résidus particulaires soit sèche.

12. Procédé selon l'une des revendications précédentes, **caractérisé en ce que** la solution de rinçage et la solution de nettoyage contiennent de l'eau dé-ionisée.

13. Procédé selon l'une des revendications précédentes, **caractérisé en ce que** le rinçage de l'étape b) est réalisé à un emplacement de rinçage qui est différent de celui utilisé pour l'étape de polissage a).

14. Procédé selon la revendication précédente, **caractérisé en ce que** l'étape de rinçage b) comprend en outre l'utilisation d'un plateau de polissage différent de celui utilisé dans l'étape de polissage a), en même temps que l'injection de la solution de rinçage.

15. Procédé selon la revendication précédente, **caractérisé en ce que** le plateau pour le polissage et le plateau pour le rinçage sont chacun recouverts d'un matériau texturé.

16. Procédé selon l'une des deux revendications précédentes, **caractérisé en ce que** l'étape de nettoyage met en oeuvre un plateau de polissage associé à une solution de nettoyage.

17. Procédé selon la revendication précédente, **caractérisé en ce que** le plateau pour le nettoyage est un plateau distinct du plateau pour le polissage et du plateau pour le rinçage.

18. Procédé selon la revendication précédente, **caractérisé en ce que** le plateau pour le nettoyage est recouvert d'un matériau texturé.

19. Procédé selon l'une des revendications précédentes, **caractérisé en ce qu'**il comprend en outre le traitement de la surface de la tranche pour former un composant de circuit intégré qui est accueilli par le matériau de la surface de la tranche.

20. Procédé selon les revendications précédentes, **caractérisé en ce qu'**il comprend en outre le séchage de la tranche avant un traitement ultérieur.

21. Application d'un procédé selon l'une des revendications précédentes, à une CMP d'une structure de type semi-conducteur sur isolant, le semi-conducteur étant en un matériau contenant au moins en partie du silicium.

22. Application du procédé selon la revendication précédente, pour laquelle l'isolant est la silice, le verre ou le quartz.
